(19) Europäisches Patentamt
European Patent Office
Office européen des brevets

(11) Publication number: 0 095 388 B1

# (12) EUROPEAN PATENT SPECIFICATION

(45) Date of publication of patent specification: 19.11.87

(51) Int. Cl.$^4$: G 03 F 7/08

(21) Application number: 83303026.5

(22) Date of filing: 25.05.83

## (54) Positive-type photoresist compositions.

(30) Priority: 25.05.82 JP 89482/82

(43) Date of publication of application:
30.11.83 Bulletin 83/48

(45) Publication of the grant of the patent:
19.11.87 Bulletin 87/47

(84) Designated Contracting States:
BE DE FR IT NL

(56) References cited:
EP-A-0 045 639
FR-A-2 523 324
US-A-3 402 044
US-A-3 869 292
THE JOURNAL OF ORGANIC CHEMISTRY, vol. 23, April 1958 (EASTON, PENNSYLVANIA, US) B.B. CORSON et al.: "Preparation of vinylphenols and isopropenylphenols", pages 544-549
PATENTS ABSTRACTS OF JAPAN, vol. 1, no. 21, 25 March 1977, page 923E76

The file contains technical information submitted after the application was filed and not included in this specification

(73) Proprietor: SUMITOMO CHEMICAL COMPANY, LIMITED
15 Kitahama 5-chome Higashi-ku
Osaka-shi Osaka 541 (JP)

(72) Inventor: Hanabata, Makoto
No. 2-1, Kuwata-cho
Ibaraki-shi Osaka (JP)
Inventor: Furuta, Akihiro
No. 1-1933-25, Miyanokawahara
Takatsuki-shi Osaka (JP)
Inventor: Yasui, Seimei
No. 3-11-10, Nakayamasakuradai
Takarazuka-shi Hyogo (JP)
Inventor: Tanaka, Kunihiko
No. 6-5-41-201, Ayameikeminami
Nara-shi Nara (JP)

(74) Representative: Moore, Anthony John et al
Gee & Co. Chancery House Chancery Lane
London WC2A 1QU (GB)

(56) References cited:
JAPANESE PATENTS REPORT, vol. 77, no. 37, 14 October 1977, page G3 (LONDON, GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 095 388 B1

Courier Press, Leamington Spa, England.

**Description**

This invention relates to positive-type photoresist compositions.

Photo-sensitive compositions containing a compound having a naphthoquinonediazido group or a benzoquinonediazido group have been used for positive-type photoresists or positive-type PS (presensitized) plates utilizing the phenomenon that when irradiated with light having a wavelength of from 300 to 500 µm, the quinonediazido group undergoes decomposition to produce a carboxyl group, whereby the compositions change from alkali-insoluble to alkali-soluble. The compounds having a naphthoquinonediazido group or a benzoquinonediazido group can be obtained by, for example, condensing naphthoquinonediazide-sulfonyl chloride or benzoquinonediazide-sulfonyl chloride with a hydroxy group-containing low or high molecular weight compound in the presence of a weak alkali. Examples of low molecular weight compounds include hydroquinone, resorcin, phloroglucin, 2,4-dihydroxybenzophenone, 2,3,4-trihydroxybenzophenone and alkyl gallates, and examples of the high molecular weight compounds include phenol-formaldehyde novolak resins, cresol-formaldehyde novolak resins and polyhydroxystyrenes.

The photo-sensitive compositions containing the above-described photo-sensitizers usually contain a resin component in addition to those described above. This resin component is necessary for providing a uniform and tough coating film which is practically usable in a photoresist or presensitized plate. In addition, the resin component is required to be developable with alkalis. As such a resin, a novolak resin is best, and phenol-formaldehyde novolak resins and cresol-formaldehyde novolak resins have enjoyed widespread practical use.

These positive-type photoresists generally have excellent resolving power as compared with photocurable (negative-type) photoresists. Because of this high resolving power, the positive-type photoresists have been used as etchant-resisting films (resist films) in photographic etching for the preparation of integrated circuits, such as IC or LSI (large-scale integrated circuit), or photographically etching a copper-laminated base plate to form a printed circuit.

The increasingly high integration degree now required of integrated circuits demands the formation of a fine pattern having lines as narrow as 1 µm. In such a fine pattern, the film properties of the resist film and its intimate adhesiveness to the base plate, as well as high resolving power, are of extreme importance. That is, fine lines or patterns of about 1 µm in width are required to be strongly adhered to the base plate without delamination and formation of pinholes during the steps of developing the resist film and etching. In these regards, conventional-type photoresist compositions, particularly positive-type photoresists containing a novolak resin and, as a photo-sensitizer, a quinonediazide compound, are not fully satisfactory. Such unsufficiency results from the nature of the novolak resin used in the photoresist. In general, in order to obtain a film having good properties, i.e., a soft, dense, tough and thin film, having good intimate adhesiveness to the base plate, it is required that the composition contains a compound having a considerable molecular weight. However, novolak resins have the defect that their degree of polymerization is difficult to increase (a forced increase in the molecular weight tends to result in the formation of gelatin, thus causing difficulty in controlling the reaction). Therefore, the resulting film is fragile, and suffers from insufficient adhesiveness to the base plate and insufficient etching resistance; it is thus liable to cause various difficulties such as pattern delamination and pinhole formation. Further, in producing novolak resins, microgels are liable to be formed, which can also lead to formation of pinholes. Other defects of novolak resins are that they have a wide molecular weight distribution and they tend to occur as mixtures of many isomers. Desirably, for use as a photoresist, the molecular weight distribution is narrow, and hence such novolak resins are usually subjected to a separation procedure to obtain a resin having a narrow molecular weight distribution. However, this procedure requires much labor and time, and even after the separation procedure, the resulting novolak resin is often still unsatisfactory. An attempt to obtain novolak resins having a narrow molecular weight distribution by controlling the production conditions has been found to be impracticable due to difficulties in control. The wide molecular weight distribution or presence of a mixture of many isomers causes the disadvantage that contrast (usually expressed as $\gamma$ value), which is one of the important properties of photoresists, is low. Low contrast results in non-sharp patterns and formation of "reverse trapezoidal" or "semicircular" patterns, which leads to seriously impaired resolving power and etching resistance, causing formation of pinholes and reduction in yield.

A further defect of novolak resins is that quality control of the production of the resin is difficult.

As described hereinbefore, novolak resin, which are liable to be gelled, have a wide molecular weight distribution, and are liable to contain many isomers, are difficult to produce as products with stable quality, and hence, lot-to-lot scatter in resist performance is very wide, which is extremely disadvantageous for users.

The aim of the present invention is to provide a resist composition which possesses good film properties and good adhesiveness, gives a pinhole-free, tough film, and which facilitates quality control of the product.

According to the present invention there is provided a positive-type photoresist composition comprising a resin and, as a photo-sensitizer, a quinonediazide compound, characterized in that said resin is

(a) a hydroxy-α-methylstyrene copolymer, which is containing at least 20% of hydroxy-α-methylstyrene monomer units, and wherein the comonomer is selected from styrene derivatives, acrylic acid derivatives and methacrylic acid derivatives; or

(b) a novolak resin containing 1 wt% or more, based on the weight of said novolak resin, of poly-(hydroxy-α-methyl-styrene) or of said hydroxy-α-methylstyrene copolymer.

The poly(hydroxy-α-methylstyrenes) which can be used in the present invention are isopropenyphenol polymers having repeating units represented by the following formula:

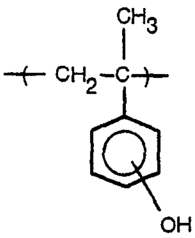

Polymers having an isopropenylphenol as a monomer unit are disclosed in, for example, Japanese Publication No. 16061/73, Japanese Patent Application (OPI) No. 50393/77 and German Patent 1,004,168. (OPI herein used means an unexamined published Japanese patent application). These polymers are all low molecular weight polymers having a molecular weight of from about 300 to about 3,000. In contrast, Japanese Patent Application No. 161412/81 discloses high molecular weight polymers having a weight average molecular weight of $5 \times 10^4$ to $5 \times 10^5$. Of these, the polyhydroxy-α-methylstyrenes suitable for use in the present invention are those having a molecular weight of from 1,000 to 100,000. The use of poly-hydroxy-α-methylstyrenes having a molecular weight falling within this range affords a pinhole-free, tough film which enables one to form a pattern with high resolving power and which shows, after formation of the resist pattern, remarkably improved intimate adhesiveness to a base plate, without impairing the developability of the positive-type photoresist.

The content of hydroxy-α-methylstyrene in the hydroxy-α-methylstyrene copolymer is 20% or more. As the comonomer there must be used a monomer selected so that the resulting copolymer is developable with alkalis and soluble in the solvent used for the resist composition, and the comonomer is compatible with the other components used in the resist composition. Suitable comonomers are styrene derivatives (e.g., styrene, hydroxystyrene and α-methylstyrene; acrylic acid derivatives (e.g. acrylic acid, methyl acrylate, ethyl acrylate and butyl acrylates); and methacrylic acid derivatives (e.g., methyl methacrylate, ethyl methacrylate and butyl methacrylate).

In using such a poly(hydroxy-α-methylstyrene) or hydroxy-α-methylstyrene copolymer in combination with a novolak resin, the poly(hydroxy-α-methylstyrene) or hydroxy-α-methylstyrene copolymer is used in an amount of 1 wt% or more based on the weight of the novolak resin.

Since the poly(hydroxy-α-methylstyrene) or hydroxy-α-methylstyrene copolymer is compatible with the novolak resin and quinonediazide compound, developable with alkalis, and soluble in a solvent usually used for photoresists such as 2-ethoxy ethanol, 2-ethoxy ethyl acetate, butyl acetate, methyl isobutyl ketone and xylene, it can be suitably used as a photoresist.

In addition, in comparison with the novolak resins alone, the poly(hydroxy-α-methylstyrene) or hydroxy-α-methylstyrene copolymer has excellent polymerization behaviour which gives quality stability. In other words, the choice of these polymers facilitates quality control of the product. Further, the poly-(hydroxy-α-methylstyrene) or hydroxy-α-methylstyrene copolymer is also very preferable in that it affords a coating film having good film properties and intimate adhesiveness without adversely affecting sensitivity, contrast, resolving power and image reproducibility, which are properties that photoresists should essentially possess.

The photo-sensitizer will now be described below. A quinonediazido group-containing photo-sensitizer component can be obtained by reacting naphthoquinonediazide-sulfonyl chloride or benzoquinonediazide-sulfonyl chloride with a low molecular weight or high molecular weight compound having a functional group capable of undergoing condensation reaction with an acid chloride. As the functional group capable of undergoing the condensation reaction with an acid chloride, there may be instanced a hydroxy group or an amino group, with the hydroxy group being preferable. Examples of low molecular weight compounds containing a hydroxy group include hydroquinone, resorcin, phloroglucin, 2,4-dihydroxybenzophenone, 2,3,4-trihydroxybenzophenone and alkyl gallates; and examples of high molecular weight compounds containing a hydroxy group include phenol-formaldehyde novolak resins, cresol-formaldehyde novolak resins, polyhydroxystyrenes and poly(hydroxy-α-methylstyrenes).

A suitable ratio of the above-described photo-sensitizer component to the hydroxy-α-methylstyrene copolymer is in the range of from 1:1 to 1:6 by weight. When using a novolak resin in combination, a suitable ratio of the photo-sensitizer component to the sum of the poly(hydroxy-α-methylstyrene) or hydroxy-α-methylstyrene copolymer and the novolak resin is again in the range of from 1:1 to 1:6 by weight.

The above-described components are dissolved in a solvent to prepare a resist solution. Suitable examples of solvents which may be used are those which can evaporate at a suitable drying rate to provide a uniform and smooth coating film. Examples of such solvents are 2-methoxy or ethoxy ethanol or the acetates thereof, butyl acetate, methyl isobutyl ketone and xylene. These solvents may be used either alone or in combination.

The positive-type photoresist compositions of the present invention can further contain small amounts of additives, such as resins, plasticizers and pigments.

The photoresist compositions of the present invention show high resolving power and extremely good intimate adhesiveness to a base plate and form fewer pinholes. Hence, they can be used for the preparation of an LSI with a pattern of approximately 1 μm. In addition, they find various other applications including shadow mask processing, color filter processing for a CCD (charge coupled device), printed circuit processing and in the production of presensitized lithographic plates.

The present invention will now be described in more detail by the following Examples which, however, should not be construed as limiting the present invention in any way.

Example 1

| | | |
|---|---|---|
| (1) | Photo-sensitizer (a condensation reaction product between naphthoquinone-(1,2)-diazide-(2)-5-sulfonyl chloride and 2,3,4-trihydroxybenzophenone) | 7 g |
| (2) | A copolymer of *m*-hydroxy-α-methylstyrene and n-butyl acrylate (weight average molecular weight: about 10,000; butyl acrylate content: 20 wt%) | 17 g |
| (3) | Dye (Sumiplast Red AS; made by Sumitomo Chemical Company, Limited) | 0.15 g |
| (4) | Solvent: 2-ethoxy ethyl acetate: 80 wt%<br>xylene: 10 wt%<br>*n*-butyl acetate: 10 wt% | 64 g |

The above-described composition was filtered through a 0.2 μm pore size filter to prepare a resist solution. This solution was coated on a silicon wafer which had been washed in a conventional manner using a rotary coater and dried for 30 minutes in a clean oven at 80°C. The thus-formed coating film had a thickness of 1.25 μm. The assembly was then exposed for 8 seconds through a mask having a minimum line width of 1.0 μm using a contact mask aligner containing a 350-W super-high pressure mercury vapor lamp as a light source. The thus-exposed assembly was dipped in a 0.25 N potassium hydroxide aqueous solution, followed by development. After development, the resulting patern was surveyed under a microscope to find that a 1.0 μm wide pattern was formed with good reproducibility and good intimate adhesiveness to the wafer; in addition, no cracks and pinholes were found in the film. Thus, the film showed good film properties.

Example 2

| | | |
|---|---|---|
| (1) | Alkali-soluble phenol-formaldehyde novolak resin | 17 g |
| (2) | Photo-sensitizer (a condensation reaction product between naphthoquinone-(1,2)-diazide-(2)-5-sulfonyl chloride and 2,3,4-trihydroxybenzophenone) | 7 g |
| (3) | Poly-*m*-hydroxy-α-methylstyrene (weight average molecular weight: 50,000) | 2 g |
| (4) | Dye (Sumiplast Red AS; made by Sumitomo Chemical Company, Limited) | 0.15 g |
| (5) | Solvent: 2-ethoxy ethyl acetate: 80 wt%<br>xylene: 10 wt%<br>*n*-butyl acetate: 10 wt% | |

The above-described composition was filtered through a 0.2 μm pore size filter and coated on a silicone wafer in the same manner as in Example 1 to obtain a pinhole-free, tough film. Then, exposure and development were conducted in the same manner as in Example 1 to form a 1.0 μm pattern on the wafer with good reproducibility and good intimate adhesiveness.

Example 3

| | | |
|---|---|---|
| (1) | Alkali-soluble phenol-formaldehyde novolak resin | 17 g |
| (2) | Photo-sensitizer (a condensation reaction product between naphthoquinone-(1,2)-diazide-(2)-5-sulfonyl chloride and 2,4-dihydroxybenzophenone) | 7 g |

(3) A copolymer of *m*-hydroxy-α-methylstyrene and n-butyl acrylate (weight average molecular weight: about 50,000; butyl acrylate content: 30 wt%) 2 g

(4) Dye (Sumiplast Red AS; made by Sumitomo Chemical Company, Limited) 0.15 g

(5) Solvent: 2-ethoxy ethyl acetate: 80 wt%
xylene: 10 wt%
*n*-butyl acetate: 10 wt%

The above described composition was filtered through a 0.2 μm pore size filter, and coated, exposed and developed in the same manner as in Example 1. Thus, a 1.0 μm pattern was formed on the wafer with good reproducibility and good intimate adhesiveness to the wafer.

**Claims**

1. A positive-type photoresist composition comprising a resin and, as a photo-sensitizer, a quinonediazide compound, characterized in that said resin is

(a) a hydroxy-α-methylstyrene copolymer, which contains at least 20% of hydroxy-α-methyl-styrene monomer units, and wherein the comonomer is selected from styrene derivatives, acrylic acid derivatives and methacrylic acid derivatives; or

(b) a novolak resin containing 1 wt% or more, based on the weight of said novolak resin, of poly(hydroxy-α-methyl-styrene) or of said hydroxy-α-methylstyrene copolymer.

2. A composition as claimed in Claim 1, in which the ratio of quinonediazide compound to said resin is from 1:1 to 1:6 by weight.

3. A base plate having coated on a surface thereof a layer formed of a composition as claimed in Claim 1 or 2.

**Patentansprüche**

1. Photoresist-Zusammensetzung vom positiven Typ, umfassend ein Harz und als einen Photo-Sensibilisator, eine Chinondiazid-Verbindung, dadurch gekennzeichnet, daß das Harz

(a) ein Hydroxy-α-methylstyrol-Copolymerisat, das mindestens 20% Hydroxy-α-methylstyrol-Monomereinheiten enthält und bei dem das Comonomere ein Styrol-Derivat, Acrylsäure-Derivat und/oder Methacrylsäure-Derivat ist; oder

(b) ein Novolakharz, das mindestens 1 Gewichtsprozent bezogen auf das Gewicht des Novolakharzes, Poly(hydroxy-α-methylstyrol) oder des genannten Hydroxy-α-methylstyrol-Copolymerisates enthält, ist.

2. Zusammensetzung nach Anspruch 1, in der das Gewichtsverhältnis von Chinondiazid-Verbindung zum genannten Harz 1:1 bis 1:6 beträgt.

3. Basisplatte, die auf einer ihrer Oberflächen eine Schicht aus einer Zusammensetzung nach Anspruch 1 oder 2 aufgebracht hat.

**Revendications**

1. Composition de réserve photographie du type positif comprenant une résine et, comme photosensibilisateur, un composé de quinonediazide, caractérisée en ce que ladite résine est

(a) un copolymère d'hydroxy-α-méthylstyrène qui contient au moins 20% de motifs d'hydroxy-α-méthylstyrène monomère et dans lequel le comonomère est choisi parmi les dérivés de styrène, les dérivés d'acide acrylique et les dérivés d'acide méthacrylique; ou

(b) une résine novolaque contenant 1% en poids ou plus, par rapport au poids de ladite résine novolaque, de poly(hydroxy-α-méthylstyrène) ou dudit copolymère d'hydroxy-α-méthylstyrène.

2. Composition selon la revendication 1, dans laquelle le rapport du composé de quinonediazide à ladite résine est de 1:1 à 1:6 en poids.

3. Plaque de support dont une face est revêtue avec une couche formée d'une composition selon la revendication 1 ou 2.